# EUROPÄISCHE PATENTSCHRIFT

(11) **EP 0 892 928 B1**
(45) Veröffentlichungstag und Bekanntmachung des Hinweises auf die Patenterteilung: **17.10.2001**
(21) Anmeldenummer: 97907011.7
(22) Anmeldetag: 23.01.1997
(51) Int. Cl.: G01R 33/09, H01L 43/12

(54) **VERFAHREN ZUR HERSTELLUNG EINES GMR-BRÜCKENSENSORS**
PROCESS FOR MANUFACTURE OF A GMR BRIDGE SENSOR
PROCEDE POUR FABRIQUER UN CAPTEUR A PONT A EFFET DE RAPPORT MAGNETORESISTIF GEANT (GMR)

(30) Priorität: 12.04.1996 DE 19614460
(43) Veröffentlichungstag der Anmeldung: 27.01.1999
(73) Patentinhaber: ROBERT BOSCH GMBH, 70442 Stuttgart (DE)
(72) Erfinder: NEUMANN, Christian, D-71696 Möglingen (DE); MARX, Klaus, D-70563 Stuttgart (DE); JOST, Franz, D-70565 Stuttgart (DE); FREITAG, Martin, D-53797 Lohmar (DE); SENGHAAS, Dietmar, D-74080 Heilbronn (DE)
(86) Internationale Anmeldenummer: DE9700110
(87) Internationale Veröffentlichungsnummer: WO9739364

(56) Entgegenhaltungen:
- EP-A- 0 622 781
- WO-A-96/38739
- IEEE TRANSACTIONS ON MAGNETICS, Bd. 32, Nr. 2, März 1996, Seiten 366-371, XP000555504 SPONG J K ET AL: "GIANT MAGNETORESISTIVE SPIN VALVE BRIDGE SENSOR"
- SCIENCE, Bd. 261, 20.August 1993, USA, Seiten 1021-1024, XP000673482 HYLTON T L ET AL: "Giant magnetoresistance at low fields in discontinuous NiFe-Ag multilayer thin films" in der Anmeldung erwähnt
- PROCEEDINGS OF THE FOURTH INTERNATIONAL SYMPOSIUM ON MAGNETIC MATERIALS, PROCESSES, AND DEVICES. APPLICATIONS TO STORAGE AND MICROELECTROMECHANICAL SYSTEMS, PENNINGTON, IL, USA, 9-12 OKTOBER 1995, ELECTROCHEMICAL SOCIETY PROCEEDINGS, Bd. 95, Nr. 18, 1996, Seiten 103-118, XP000674878 DAUGHTON J M: "GMR sensors"

## Beschreibung

### Stand der Technik

Die Erfindung bezieht sich auf einen GMR-Brückensensor, bei dem zur Feststellung eines magnetischen Feldes magnetoresistive Widerstände in Form einer Brücke zusammengeschaltet sind.

Ein solcher GMR-Brückensensor und auch ein Verfahren zu seiner Herstellung, wie im Oberbegriff des Anspruchs 1 niedergelegt, sind bekannt aus dem Dokument IEEE Transactions on Magnetics, Bd. 32, Nr. 2, März 1996, Seiten 366 - 371; J.K. Spong et al.: Giant Magnetoresistive Spin Valve Bridge Sensor. Bei diesem Sensor werden die GMR-Eigenschaften der einzelnen Elemente direkt bei deren Herstellung festgelegt.

In einem GMR-Brückensensor der Firma Nonvolatile Inc., Eden Prairie, MN 55344, USA, der in einem Firmenprospekt vom August 1995 als NVS5B50 GMR Bridge Sensor beschrieben ist, sind zur Feststellung von magnetischen Feldern vier Widerstände aus GMR-Material zu einer Wheatstone-schen Brücke zusammengeschaltet. Bei diesem bekannten Brückensensor sind zwei der vier Widerstände durch dickes magnetisches Material magnetisch abgeschirmt, um somit feste Widerstands-Referenzwerte zu haben, und zwei weitere Widerstände ändern ihren Widerstand entsprechend dem angelegten, bzw. dem zu messenden Magnetfeld. Die Änderung des Widerstandswertes dieser beiden Widerstände kann zu einer Spannungsänderung von ca. 5 - 6% der angelegten Spannung führen. Die beiden dem Magnetfeld ausgesetzten Widerstände, die ihren Widerstand ändern, sind zwischen besonders gestalteten Magnetfluß-Konzentratoren angeordnet. Dadurch ist der Sensor bei Feldern gesättigt, die kleiner sind als die Sättigungsfelder des verwendeten GMR-Materials selbst. Diese bekannte Anordnung zeigt, wie schwierig es ist und welchen erheblichen Aufwand es erfoderlich macht, die Widerstände einer Brückenschaltung so zu manipulieren, daß sie unterschiedlich sensitiv auf das äußere Magnetfeld werden und reagieren.

GMR bedeutet Giant Magnetoresistive Ratio, d. h. daß die magnetoresitiven Eigenschaften dieses Materials, also dessen magnetoresistiver Effekt, wesentlich und erheblich größer sind, als bei üblichem magnetoresistivem Material. In einem Artikel "Giant Magnetoresistance at Low Fields in Discontinuous NiFe-Ag Multilayer Thin Films" von T.L. Hylton, K.R. Coffey, M.A. Parker, J.K. Howard, erschienen in SCIENCE, VOL. 261, 20. August 1993, Seiten 1021 - 1024, werden verschiedene mehrschichtige Dünnfilm-Anordnungen beschrieben, welche aus der Materialkombination NiFe/Ag in jeweils unterschiedlichen Schichtdicken bestehen. Bei diesen Materialien wird durch Erwärmen oder Tempern bei einer bestimmten Temperatur von etwa 330°C eine wesentlich erhöhte magnetoresistive Empfindlichkeit beobachtet. Bei dem Tempervorgang entstehen diskontinuierliche Schichtstrukturen, durch welche der GMR-Effekt bewirkt sein soll. Das Tempern wird durch normale Erwärmung der Materials und anschließendes Abkühlen vorgenommen. Über eine besondere Anordnung dieser Materialien in bestimmter Anwendungsweise ist in dieser Literaturstelle nichts ausgesagt.

Die Druckschrift WO 96/38739, die das Prioritätsdatum 01.06.95 beansprucht und am 05.12.96 veröffentlicht wurde, offenbart einen GMR-Brückensensor der mittels eines Verfahrens hergestellt wird, das ähnlich dem im vorliegenden Anspruch 1 definierten ist. Bei dem in WO 96/38739 vorgeschlagenen Verfahren kann der für das magnetische Einstellfeld benötigte Einstellstrom auch dazu herangezogen werden, die Heizleistung für eine erwünschte Temperaturerhöhung auf etwa 150°C zu erbringen. Allerdings wird dieser Einstellstrom über die das magnetische Einstellfeld erzeugende Leiterschicht an einen Brückenwiderstand direkt, und nicht an den zwei Brückenwiderstände verbindenden Brückenanschluß als solchen, geführt.

### Vorteile der Erfindung

Das erfindungsgemäße Verfahren zur Herstellung eines GMR-Brückensensors mit den kennzeichnenden Merkmalen des Anspruchs 1 hat demgegenüber den Vorteil des wesentlich vereinfachten und sehr gut kontrollier- und dosierbaren Temperns der Widerstände. Daraus resultiert ein wesentlich kostengüngstigeres Herstellungsverfahren von GMR-Brückensensoren sowie damit einhergehend ein kostengünstigeres Bauteil.

Gemäß der Erfindung wird dies prinzipiell dadurch erreicht, daß die GMR-Eigenschaft der einzelnen Widerstände durch Tempern hervorgerufen wird, daß das Tempern der Widerstände durch ausgewähltes Einspeisen eines Stromes, welcher für das Erreichen der für das Tempern notwendigen Temperatur ausreicht, an den zu den Brückenwiderständen führenden Brückenanschlüssen durchgeführt wird und damit die Widerstände mit der GMR-Eigenschaft versehen werden.

Durch die in weiteren Verfahrensansprüchen niedergelegten Maßnahmen sind vorteilhafte Weiterbildungen und Verbesserungen des im Anspruch 1 angegebenen Vefahrens möglich.

Entsprechend einer besonders vorteilhaften ersten Ausführungsform des erfindungsgemäßen Verfahrens wird jeder Widerstand einzeln durch Anlegen einer für das Tempern ausreichenden Spannung an den zu den Brückenwiderständen führenden, unmittelbar benachbarten Brückenanschlüssen und durch die hierdurch eingespeisten Ströme auf die zum Tempern ausreichende Temperatur erwärmt, und jeder Widerstand danach abkühlt.

Entsprechend einer besonders vorteilhaften zweiten Ausführungsform des erfindungsgemäßen Verfahrens ist vorgesehen, daß jeweils zwei in verschiedenen Brückenzweigen liegende Widerstände dadurch getempert werden, daß die Stromeinspeisung über jeweils zwei unmittelbar benachbarte, auf gleiches Potential gelegte Brückenanschlüsse erfolgt.

In besonders zweckmäßiger weiterer Ausgestaltung des erfindungsgemäßen Verfahrens weisen die einzelnen Widerstände vor dem Tempern jeweils den gleichen Widerstandswert auf. Vorteilhafterweise erfolgt das Einspeisen des geeigneten Stromes beim erfindungsgemäßen Verfahren einmalig.

Das erfindungsgemäße Verfahren ist in besonders zweckmäßiger Ausgestaltung zur Herstellung von GMR-Brückensensoren geeignet, wenn als Material für die Widerstände ein Material der Klasse der diskontinuierlichen Mehrschichtmaterialien, insbesondere NiFe/Ag, verwendet ist, bei welchen die GMR-Eigenschaft durch Tempern mit einer bestimmten Temperatur hervorrufbar ist.

### Zeichnung

Die Erfindung ist anhand eines in der Zeichnung dargestellten Ausführungsbeispiels in der nachfolgenden Beschreibung näher erläutert. Es zeigt:

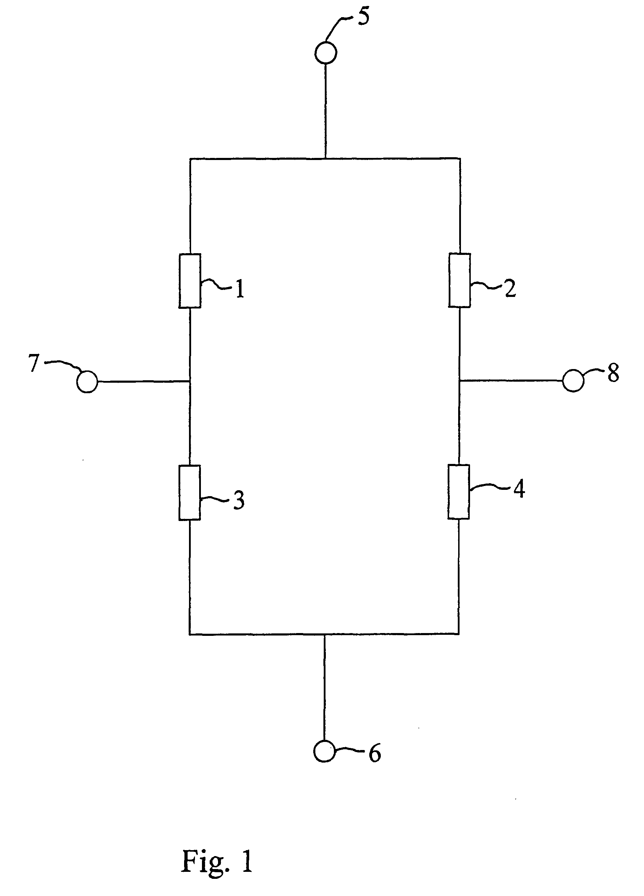

- Fig. 1: schematisch eine Brückenschaltung von vier Widerständen und die zugehörigen vier Brückenanschlüsse.

### Beschreibung des Ausführungsbeispiels

In Fig. 1 ist schematisch eine Brückenschaltung von vier Widerständen 1, 2, 3, 4 mit zugehörigen vier Brückenanschlüssen 5, 6, 7 und 8 dargestellt. Die vier Widerstände 1 - 4 sind aus einem Material hergestellt, welches nach einem Temperprozeß den sogenannten GMR-Effekt aufweist. Dadurch bildet die Brückenschaltung einen idealen magnetoresistiven Sensor, der eine hohe Empfindlichkeit zur Messung von magnetischen Feldern hat. Als GMR-Material wird vorzugsweise eines der Klasse der sogenannten diskontinuierlichen Mehrschichtanordnungen, insbesondere hergestellt in Dünnschichttechnik aus der Materialkombination von NiFe und Ag. Für den Temperprozeß dieser Materialien sind Temperaturen von ca. 300°C oder etwas mehr erforderlich, damit die Anordnung sich so verändert, daß sie dauerhaft den GMR-Effekt zeigt. Der Temperprozeß wird nur einmal durchgeführt.

Entsprechend dem erfindungsgemäßen Verfahren wird der Temperprozeß erst nach Beendigung der in Dünnschicht-Technologie erfolgenden kompletten Herstellung des Sensors in seiner Brückenkonstellation durchgeführt. Es liegt also vor dem Tempern das eigentliche Bauelement bereits fertig vor. Das Tempern erfolgt erfindungsgemäß durch Stromeinspeisung an den zu den Brückenwirderständen führenden, entsprechenden Brückenanschlüssen. Dabei können die Brückenwiderstände entweder einzeln oder zu zweit in verschiedenen Brückenzweigen getempert werden. Die Stärke des Stromes wird so gewählt, daß eine ausreichende Stromdichte erreicht wird, um die zum Tempern notwendige Temperatur am Ort des jeweiligen Widerstandes zu erreichen.

Eine erste Ausführungsform des erfindungsgemäßen Verfahrens sieht das einzelne Tempern jeden Widerstands vor. Dazu wird an den unmittelbar benachbarten Anschlüssen jeden Widerstands ein zum Tempern ausreichender Strom eingespeist. Zum einmaligen Tempern beispielsweise des Widerstands 2 wird die Stromeinspeisung an Anschluß 5 und 8 vorgenommen. Bei genügend großer Stromdichte heizt sich in diesem Fall der Widerstand 2 auf, weil über ihn ein weitaus größerer Strom fließt als durch die bei dieser Konstellation in Reihe geschalteten Widerstände 1, 3 und 4. Damit ist selektiv dieser Widerstand 2 gezielt in seinem GMR-Verhalten gegenüber den anderen Widerständen 1, 3 und 4 zu verändern. In vorteilhafter Weise sind die Ausgangswerte der vier Widerstände 1 - 4 gleich groß. Dies vereinfacht auch die Herstellung in Dünnfilm-Technologie. Aus der nachfolgenden Tabelle 1 ist ersichtlich, wie das Tempern der einzelnen Widerstände 1 - 4 gemäß der in Fig. 1 dargestellten Konfiguration und Beschaltung erfolgt.

**Tabelle 1**

| Stromeinspeisung an Anschluß: | Tempern von Widerstand: |
|---|---|
| 5 und 8 | 2 |
| 8 und 6 | 4 |
| 6 und 7 | 3 |
| 7 und 5 | 1 |

Mit diesem Verfahren ist man in der Lage, jeden einzelnen Widerstand der Brückenschaltung zu tempern.

Für die Praxis relevant und von besonderer Bedeutung ist der Fall, daß jeweils genau ein Widerstand der in Reihe geschalteten Widerstände jedes Brückenzweiges unterschiedlich auf das äußere Magnetfeld reagiert. Dazu wird entsprechend einer besonders vorteilhaften zweiten Ausführungsform des erfindungsgemäßen Verfahrens die Stromeinspeisung über jeweils zwei unmittelbar benachbarte, auf gleiches Potential gelegte Brückenanschlüsse durchgeführt. In einem Fall wird die Stromeinspeisung sowohl gleichzeitig an den Anschlüssen 5 und 7 als auch an den Anschlüssen 8 und 6 vorgenommen, wobei die Anschlüsse 5 und 8 sowie 7 und 6 jeweils auf das gleiche Potential gelegt sind. In diesem Fall fließt der Strom ausschließlich über die Widerstände 1 und 4, welche in verschiedenen Brückenzweigen liegen. Diese beiden Widerstände 1 und 4 heizen sich entsprechend auf, während die Widerstände 2 und 3 stromfrei sind. Aus der nachfolgenden Tabelle 2 ist ersichtlich, wie das Tempern einzelner Widerstände in verschiedenen Brückenzweigen gemäß der in Fig. 1 dargestellten Konfiguration und Beschaltung erfolgt.

**Tabelle 2**

| Stromeinspeisung an Anschluß: | gleiches elektrisches Potential an Anschluß: | Tempern von Widerstand: |
|---|---|---|
| 5 & 7 ; 8 & 6 | 5 & 7 ; 8 & 6 | 2 und 3 |
| 5 & 8 ; 7 & 6 | 5 & 8 ; 7 & 6 | 1 und 4 |

Die Erfindung ermöglicht es, auf einfache und kostengünstige Weise einen GMR-Brückensensor zur Verfügung zu stellen. Das erfindungsgemäße Herstellungsverfahren macht einen wesentlichen Fertigungsabschnitt mit einem Depositions-, Lithographie- und Ätzschritt entbehrlich, was in einer erheblichen Kostenersparnis resultiert. Der Temperprozeß einzelner Widerstände oder jeweils eines Widerstands in jedem Brückenzweig ist darüber hinaus mittels der gesteuerten Stromeinspeisung relativ leicht zu kontrollieren und einfach durchzuführen. Der besondere Vorteil liegt weiterhin auch darin, daß das Mehrlagenschichtsystem deponiert wird, das Sensorlayout, d.h. die Brückenschaltung mit ihren Anschlüssen, geätzt wird und erst danach mit dem dann vorhandenen Layout zwei der vier Brückenwiderstände gemeinsam oder einzeln getempert und somit für ein äußeres Magnetfeld sensitiv gemacht werden.

## Patentansprüche

1. Verfahren zur Herstellung eines GMR-Brückensensors, bei dem zur Feststellung eines magnetischen Feldes magnetorestistive Widerstände (1 - 4) in Form einer Brücke zusammengeschaltet sind, welche aus einem Material bestehen, das den GMR-Effekt, Giant Magnetoresistive Ratio-Effekt, aufweist, **dadurch gekennzeichnet, daß** die GMR-Eigenschaft der einzelnen Widerstände (1 - 4) durch Tempern hervorgerufen wird, daß das Tempern der Widerstände durch ausgewähltetes Einspeisen eines Stromes, welcher für das Erreichen der für das Tempern notwendigen Temperatur ausreicht, an den zu den Brückenwiderständen führenden Brückenanschlüssen (5 - 8) durchgeführt wird und damit die Widerstände (1 - 4) mit der GMR-Eigenschaft versehen werden.

2. Verfahren nach Anspruch 1, **dadurch gekennzeichnet, daß** die für das Tempern ausreichende Stromeinspeisung bei jedem einzelnen Widerstand (1; 2; 3; 4) durch Anlegen einer Spannung an seinen unmittelbar benachbarten Brückenanschlüssen (5; 7; 5, 8; 6, 7; 6, 8) erfolgt und er dadurch auf die zum Tempern ausreichende Temperatur erwärmt wird, und daß jeder Widerstand (1; 2; 3; 4) danach abgekühlt wird.

3. Verfahren nach Anspruch 1, **dadurch gekennzeichnet, daß** jeweils zwei in verschiedenen Brückenzweigen liegende Widerstände (2, 3; 1, 4) dadurch getempert werden, daß die Stromeinspeisung über jeweils zwei unmittelbar benachbarte, auf gleiches Potential gelegte Brückenanschlüsse erfolgt.

4. Verfahren nach Anspruch 1, 2 oder 3, **dadurch gekennzeichnet, daß** die einzelnen Widerstände vor dem Tempern jeweils den gleichen Widerstand aufweisen.

5. Verfahren nach einem der vorigen Ansprüche, **dadurch gekennzeichnet, daß** das Einspeisen des für das Tempern ausreichenden Stromes einmalig erfolgt.

6. Verfahren nach einem der vorigen Ansprüche, **dadurch gekennzeichnet, daß** als Material für die Widerstände ein Material der Klasse der diskontinuierlichen Mehrschichtmaterialien, insbesondere NiFe/Ag, verwendet ist, bei welchen die GMR-Eigenschaft durch Tempern mit einer bestimmten Temperatur hervorrufbar ist.

7. Verfahren nach einem der Ansprüche 1-5, **dadurch gekennzeichnet, daß** als Material für die Widerstände (1 - 4) ein solches verwendet ist, welches nach einem einmaligen Temperprozeß eine andere GMR-Eigenschaft aufweist als vorher, insbesondere ein Material in Mehrschichtanordnung der Materialkombination NiFe/Ag.

## Claims

1. Method for producing a GMR bridge sensor, in which, for the purpose of ascertaining a magnetic field, magnetoresistive resistors (1-4) are connected together in the form of a bridge, which resistors are composed of a material which exhibits the GMR effect, Giant Magnetoresistive Ratio Effect, **characterized in that** the GMR property of the individual resistors (1-4) is engendered by heat treatment, **in that** the heat treatment of the resistors is carried out by selected feeding-in of a current, which suffices for reaching the temperature required for the heat treatment, at the bridge connections (5-8) leading to the bridge resistors, and the resistors (1-4) are thus provided with the GMR property.

2. Method according to Claim 1, **characterized in that** the feeding-in of current which suffices for the heat treatment is effected, in the case of each individual resistor (1; 2; 3; 4), by the application of a voltage to its directly adjacent bridge connections (5; 7; 5, 8; 6, 7; 6, 8) and it is thereby heated to the temperature sufficient for heat treatment, and **in that** each resistor (1; 2; 3; 4) is subsequently cooled.

3. Method according to Claim 1, **characterized in that** in each case two resistors (2, 3; 1, 4) located in different bridge paths are subjected to heat treatment by the feeding-in of current being effected via in each case two directly adjacent bridge connections put at the same potential.

4. Method according to Claim 1, 2 or 3, **characterized in that** the individual resistors each have the same resistance prior to the heat treatment.

5. Method according to one of the preceding claims, **characterized in that** the feeding-in of the current which suffices for the heat treatment is effected in a singular manner.

6. Method according to one of the preceding claims, **characterized in that** the material used for the resistors is a material of the class of discontinuous multilayer materials, in particular NiFe/Ag, in which the GMR property can be engendered by heat treatment at a specific temperature.

7. Method according to one of Claims 1-5, **characterized in that** the material used for the resistors (1-4) is one which, after a singular heat-treatment process, has a different GMR property than before, in particular a material in a multilayer arrangement of the material combination NiFe/Ag.

## Revendications

1. Procédé de fabrication d'un capteur en pont GMR comportant des résistances magnétorésistives (1-4) combinées sous la forme d'un pont pour détecter un champ magnétique, ces résistances étant réalisées dans une matière ayant l'effet GMR (effet magnétorésistif géant),
**caractérisé en ce qu'**
on produit par trempe les propriétés GMR des différentes résistances (1-4), on effectue la trempe des résistances par une alimentation sélectionnée d'un courant suffisant pour atteindre la température nécessaire à la trempe en appliquant ce courant aux bornes du pont (5-8) reliées aux résistances, et on communique ainsi aux résistances (1-4) les propriétés GMR.

2. Procédé selon la revendication 1,
**caractérisé en ce que**
l'alimentation électrique suffisante pour la trempe de chacune des différentes résistances (1, 2, 3, 4), se fait par l'application d'une tension aux bornes de branchement du pont (5, 7 ; 5, 8 ; 6, 7 ; 6, 8) directement voisines, et l'on chauffe ainsi à une température suffisante pour la trempe, puis on refroidit chaque résistance (1, 2, 3, 4).

3. Procédé selon la revendication 1,
**caractérisé en ce qu'**
on trempe chaque fois deux résistances (2, 3 ; 1, 4) situées dans des branches de pont différentes,
l'alimentation électrique se faisant chaque fois par deux bornes de branchement du pont, directement voisines, mises au même potentiel.

4. Procédé selon l'une quelconque des revendications 1, 2 ou 3,
**caractérisé en ce qu'**
avant la trempe, les différentes résistances ont la même valeur.

5. Procédé selon l'une quelconque des revendications précédentes,
**caractérise en ce que**
l'alimentation du courant suffisant pour la trempe se fait une seule fois.

6. Procédé selon l'une quelconque des revendications précédentes,
**caractérisé en ce que**
comme matière pour les résistances, on utilise une matière de la classe des matières multicouches discontinues, notamment NiFe/Ag, dont on produit les propriétés GMR par trempe à une certaine température.

7. Procédé selon l'une quelconque des revendications 1 à 5,
**caractérisé en ce que**
comme matière pour les résistances (1-4), on utilise une matière qui, après une opération de trempe, présente d'autres propriétés GMR que précédemment, notamment une matière en disposition multicouche de la combinaison de matières NiFe/Ag.
